(19) Europäisches Patentamt
European Patent Office
Office européen des brevets

(11) **EP 3 517 938 B1**

(12) **EUROPEAN PATENT SPECIFICATION**

(45) Date of publication and mention
of the grant of the patent:
**16.09.2020 Bulletin 2020/38**

(51) Int Cl.:
**G01N 21/77** *(2006.01)*     *G02B 6/024* *(2006.01)*
*G02B 6/24* *(2006.01)*        *G01R 31/36* *(2020.01)*
*G02B 6/255* *(2006.01)*       *G02B 6/26* *(2006.01)*

(21) Application number: **18154070.9**

(22) Date of filing: **30.01.2018**

(54) **OPTICAL DETECTOR AND METHOD FOR DETECTION OF A CHEMICAL COMPOUND**

OPTISCHER DETEKTOR UND VERFAHREN ZUM NACHWEIS EINER CHEMISCHEN VERBINDUNG

DÉTECTEUR OPTIQUE ET PROCÉDÉ DE DÉTECTION D'UN COMPOSÉ CHIMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.07.2019 Bulletin 2019/31**

(73) Proprietors:
• **Karlsruher Institut für Technologie**
  **76131 Karlsruhe (DE)**
• **University Of Aveiro**
  **3810-193 Aveiro (PT)**

(72) Inventors:
• **DING, Markus**
  **89231 Neu-Ulm (DE)**

• **KOCH, Stephan**
  **85375 Neufahrn bei Freising (DE)**
• **PASSERINI, Stefano**
  **89073 Ulm (DE)**
• **DE LEMOS PINTO, Joao**
  **3800-139 Aveiro (PT)**
• **DOS ANJOS FERREIRA, Marta Sofia**
  **3800-438 Aveiro (PT)**

(74) Representative: **Altmann Stößel Dick**
     **Patentanwälte PartG mbB**
     **Dudenstrasse 46**
     **68167 Mannheim (DE)**

(56) References cited:
**EP-A1- 2 565 630     JP-A- H04 315 108**
**US-A- 5 610 393     US-A1- 2015 303 723**

**Description**

Field of the invention

The present invention relates to an optical detector for a detection of a chemical compound, a method for a detection of a chemical compound, wherein such an optical detector is used, and an electrochemical energy device comprising such an optical detector.

Related art

Modern electrochemical energy devices, in particular electrochemical cells, which may be used for storing and providing electrical energy from chemical reactions, may comprise lithium, wherein, usually, the lithium may be provided in form of a lithium salt which may, specifically, be selected from lithium hexafluorophosphate ($LiPF_6$), lithium perchlorate ($LiClO_4$), lithium tetrafluoroborate ($LiBF_4$), lithium tetra-chloroaluminate ($LiAlCl_4$), lithium tetrachlorogallate ($LiGaCl_4$), or lithium bromide (LiBr). However, most of these salts are known to easily hydrolyze, whereby a fluid product, specifically, hydrofluoric acid (HF), hydrochloric acid (HCl), or hydrobromic acid (HBr), is generated, in particular, when moisture, especially in form of water molecules ($H_2O$), may be present in the electrochemical cell. Further lithium salts and additional fluid products may, however, also be generated. Hence, these fluid products can, in principle, be used as a reliable indicator for moisture. Herein, the moisture can occur in the electrochemical cell either as a result of a contamination during manufacturing of the electrochemical cell or due to an imperfect sealing of the electrochemical cell, whereby at least one of the mentioned fluid products may be generated. In addition, such a fluid product can be formed in an abuse condition, in particular, where an electrolyte solvent may decompose into one or more kinds of alcohols, which may, subsequently, decompose into one or more lithium fluoro- or chloro-compounds, whereby at least one of the above-indicated fluid products is, eventually, obtained.

L. Terborg, S. Weber, F. Blaske, S. Passerini, M. Winter, U. Karst, and S. Nowak, Investigation of thermal aging and hydrolysis mechanisms in commercial lithium ion battery electrolyte, J. Power Sources, 242 (2013), p. 832, address the detection of HF since it is considered as a dangerous chemical compound being present in current lithium ion batteries. As a result, it is desirable to detect and measure small amounts of HF.

S.-T. Myung, K. Izumi, S. Komaba, Y.-K. Sun, H. Yashiro, and N. Kumagai, Role of alumina coating on Li-Ni-Co-Mn-O particles as positive electrode material for lithium-ion batteries, Chem. Mater., 17 (2005), p. 3695; and N.P.W. Pieczonka, Z. Liu, P. Lu, K.L. Olson, J. Moote, B.R. Powell, J.H. Kim, Understanding transition-metal dissolution behavior in LiNi0.5Mn1.5O4 high-voltage spinel for lithium ion batteries, J. Phys. Chem. C, 117 (2013), p. 15947, describe that a formation of HF can partially passivate an aluminum (Al) current collector at the cathode side against oxidation. A formation of LiF at the anode side can be attributed to beneficial properties of solid-electrolyte interphases (SEI), such as a high $Li^+$ conductivity. However, after an initial Al current collector passivation and an SEI formation on the anode which, typically, comprises graphite, HF can no longer be considered as beneficial. On the contrary, its toxic and aggressive chemical properties may, usually, be detrimental to a lifetime of the electrochemical cell. HF may, on one hand, attack the SEI on the anode side, hereby, leading to strong reactions between unprotected anode partitions and the electrolyte, and, on the other hand, attack the cathode material, in particular, by dissolving transition metal ions or forming a blocking layer of LiF on top of the active cathode material, whereby a capacity of the electrochemical cell may be diminished.

I-C. Chen, S.-S. Lin, T.-J. Lin, J.-K. Du, Detection of hydrofluoric acid by a SiO2 sol-gel coating fiber-optic probe based on reflection-based localized surface plasmon resonance, Sensors 11, 2011, pp. 1907-23, describe an fiber-optic detector using a reflection-based localized surface plasmon resonance (LSPR) for determining a concentration of HF in an aqueous solution. The sensor comprises a gold nanoparticle-modified PMMA fiber having an $SiO_2$ sol-gel coating. Thus, the sensor is used to assess a relationship between HF concentration and $SiO_2$ sol-gel layer etching reduction. The results demonstrate that the LSPR sensor is capable of detecting HF-related erosion of HF solutions of concentrations of 1 % to 5 % using relative RI change rates.

M.-T. Lee, Communications of the American Ceramic Society 1984, C-21-C-22, describes studies on reactivity of different silica compositions, e.g. Ge-doped silica vs. pure silica, whereby etching rates were determined.

US 6,157,442 A discloses a sensor device for measuring a concentration of a substance within a sample comprising a sensor having an optical fiber portion having a first end and a second end, the second end having a tip portion attached thereto and an active material incorporated within the tip portion, the tip portion being adapted to be inserted into a sample, the active material capable of interacting with a substance within a sample, a light source coupled to the first end of the sensor for emitting a beam of light into and through the sensor and into a sample, the emitted beam of light having a wavelength and the active material interacting with a substance within a sample to change the wavelength of the emitted beam of light to produce a reflected beam of light and the sensor for transmitting the reflected beam of light out of the second end thereof, an optical detector for receiving the reflected beam of light from the second end of the sensor for producing a signal indicative of the reflected beam of light, and a processor for receiving the signal indicative of the reflected beam of light and for processing the signal to determine the concentration of a substance within a sample.

US 2014/0203783 A1 discloses a system including optical sensors arranged within or on portions of an electrochemical energy device, e.g., a rechargeable Li-ion battery, for measuring operating parameters, e.g., a mechanical strain and/or a temperature, of the electrochemical energy device during charge/recharge cycling. The measured parameter data is transmitted by way of light signals along optical fibers to a controller, which converts the light signals to electrical data signal using a light source/ analyzer. A processor then extracts temperature and strain data features from the data signals, and utilizes a model-based process to detect intercalation stage changes, i.e., characteristic crystalline structure changes caused by certain concentrations of guest species, such as Li-ions, within the electrode material of the electrochemical energy device, indicated by the data features. The detected intercalation stage changes are used to generate highly accurate operating state information, e.g., state-of-charge and state-of-health, and management/ control signals for optimizing charge/discharge rates.

Further documents disclose an implementation of fiber optic sensors into one or more electrochemical energy devices, such as US 2016/0028129 A1 which describes an implementation and a sealing of optical fibers in batteries or US 2016/0018319 A1 which refers to a measurement and an analysis of multiple sensors in battery packs.

US 5,610,393 A discloses a fiber optical chemical detection system for detecting the presence of hydrazine fuels and nitrogen tetroxide and nitrogen dioxide gases that are used at rocket launch sites using reversible colorimetric sensors that selectively form chemically reversible, intermolecular charge transfer-complexes with the gases that then absorb laser light communicating through a fiber optic network having a conventional diode laser source transmitting interrogation pulses to a plurality of distributed sensors covering a wide area launch site, the sensor being reactive cladding or distal end types both providing optical reflective returns well suited for reflective near infra-red and visible-red laser interrogation by an optical time domain reflectometry monitor which compares the interrogated laser pulses with sensor returns to determine the contemporaneous extent and location of gas cloud concentration over the distributed wide area.

US 2015/303723 A1 discloses a battery management system including one or more fiber optic sensors configured to be disposed within an electrochemical battery. Each fiber optic sensor is capable of receiving input light and providing output light that varies based on the input light and an amount of free or dissolved gas present within the battery. A detector detects the output light and generates an electrical detector signal in response to the output light. Battery management circuitry determines the state of the battery based at least in part on the detector signal.

EP 2565630 A1 discloses an optical sensor component for use in an optical sensor for monitoring of protease activity in wound fluid, the optical sensor component comprising, a sensing optical fiber comprising an unmodified portion and a modified portion. The modified portion is an uncladded portion, or the core of the optical fiber, and comprises a coating having a dye which is configured to absorb light, the coating being configured such that it has a predetermined sensitivity to protease such that the coating degrades upon contact with protease, wherein degradation of the coating decreases the amount of light which can be absorbed in the sensing optical fiber. There is further provided a corresponding method of detecting protease activity, and an optical sensor device and a wound dressing which comprises the optical sensor component. There is further provided a method of preparing the optical sensor component.

JP H04315108 A disclose a panda type polarization maintaining optical fibers which are immersed into a saturated solution mixture comprising hydrofluoric acid and an aqueous ammonium fluoride solution. While the panda type polarization maintaining optical fibers are heated in such a manner, the fibers are subjected to a fusing and stretching treatment under tension. Such fibers can be used for optical measurements or as optical fiber sensor.

Consequently, a presence of the above-indicated fluid products, including but not limited to HF, HCl or HBr, in the electrolyte can be considered as a clear and reliable indicator for problems occurring in the electrochemical cell, specifically, for a presence of moisture or of abnormal conditions leading to solvent decomposition.

Problem to be solved

It is therefore an objective of the present invention to provide an optical detector suitable for a detection of a chemical compound, a method for a detection of such a chemical compound, and an electrochemical device comprising such an optical detector, which at least partially overcome the above-mentioned problems of the state of the art.

It is a particular objective of the present invention to provide a method and a detector for a *real-time* detection of a chemical compound, which may, in particular, be crucial for a functioning of an electrochemical device, preferably, in an *in situ* and/or an *in operando* manner.

Summary of the invention

This problem is solved by an optical detector for a detection of a chemical compound according to claim 1, and a method for a detection of a chemical compound according to claim 10. Preferred embodiments, which might be realized in an isolated fashion or in any arbitrary combination, are listed in the dependent claims.

As used in the following, the terms "have", "comprise" or "include" or any arbitrary grammatical variations thereof are used in a non-exclusive way. Thus, these terms may refer to both a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, as used in the following, the terms "preferably", "more preferably", "particularly", "more particularly", or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in this way with other features of the invention.

In a first aspect, the present invention relates to an optical detector for a detection of a chemical compound according to claim 1. As used herein, the term "optical detector" refers to a device which is designed to determine at least one property related to the chemical compound to be detected from at least one sensor signal generated by at least one optical sensor comprised by the optical detector. According to the present invention, the optical detector comprises, among other features as defined in claim 1:

- a first optical fiber element, wherein the first optical fiber element is designed to guide at least one optical signal and at least one modified optical signal;
- a second optical fiber element, wherein the second optical fiber element is adapted to communicate with the first optical fiber element, wherein the second optical fiber element is designed to receive the at least one optical signal provided by the first optical fiber element and to emit the at least one modified optical signal to the first optical fiber element, wherein a partition of the second optical fiber element comprises a first material which is adapted to be converted into a second material upon a chemical reaction with at least one chemical compound to be detected, wherein the at least one modified optical signal depends on a conversion of the first material into the second material by the chemical compound; and
- an evaluation device, wherein the evaluation device is adapted to determine at least one property related to the chemical compound by evaluating the at least one modified optical signal provided to the evaluation device by the first optical fiber element.

Accordingly, the optical detector comprises a first optical fiber element and a second optical fiber element, wherein the first optical fiber element and the second optical fiber element may, preferably, be provided as two individual optical fiber elements, wherein, however, it may also be feasible to integrate the second optical fiber element into the first optical fiber element, in particular, at one end of the first optical fiber element. As used herein, the term "optical fiber element" refers to an optical fiber or to an optical element comprising an optical fiber. As generally used, the term "optical fiber" relates to an optical element having a first end, a second end, at least one solid core of an optical transparent material having a first refraction index $n_1$, and a cladding surrounding the at least one core of the optical fiber and having a second refraction index $n_2$, wherein the refraction indices $n_1$, $n_2$ fulfil a condition as expressed by Equation (1) that

$$n_2 < n_1. \qquad (1)$$

As a result, an optical signal introduced at the first end into the core of the optical fiber can be guided along a course of the core by a total internal reflection of the optical signal at adjacent walls of the cladding surrounding the core to the second end, or vice-versa. In particular for increased protection against the environment, the cladding of the optical fiber may, additionally, be surrounded by a coating. Due to very low propagation losses of the optical signal guided within the optical fiber, the optical fiber may have extensions being capable of bridging distances even exceeding meters.

In a particularly preferred embodiment, the first optical fiber element is or comprises a single-mode fiber having a single first core and a single first cladding, wherein the single first cladding surrounds the single first core and wherein the single first core has a core diameter which supports only a single light mode to be guided through the single-mode optical fiber. However, in principle, the present invention can also be performed by using other types of optical fibers, in particular by a multi-mode fiber, wherein the core diameter supports more than a single light mode to be guided, specifically, by a graded-index fiber, wherein the graded-index fiber has a core having a refractive index decreasing with increasing radial distance from an optical axis of the graded-index fiber.

Consequently, the optical fiber can exhibit a first function of an optical waveguide which may be designed to guide an optical signal from the first end of the optical fiber to the second end of the optical fiber, or vice-versa. According to the present invention, the first optical fiber element comprised by the optical detector can, thus, be considered as the optical waveguide designated for guiding the at least one optical signal. As a result, the first optical fiber element may, thus, be used for guiding at least one initial optical signal from a first location to a further location, such as to a remote location, where the at least one initial optical signal may be used for a particular purpose, such as for sensing at the further location. In this event, the at least one initial optical signal may be modified and, as at least one modified optical signal, guided back to the first location where it may be received and, preferably, compared to the at least one initial optical signal in a manner that evidence about a sensed property, which may be related to a sensed object, can be generated.

However, the optical fiber may itself, be at least partially, modified, such as by a pressure, a strain or a temperature exerting influence on the optical fiber, whereby the initial optical signal may be modified within the optical fiber itself to the modified optical signal. Consequently, the optical fiber can further exhibit a second function of an optical sensor being adapted to measure at least one property by which the optical fiber or a partition thereof may be affected in a manner that evidence about a sensed property, which may, again, be related to a sensed object, can be generated. According to the present invention, the second optical fiber element can, thus, be considered as an optical sensor, wherein a partition of the second optical fiber element comprises a first material, a property of which may be changed by an external influence caused by a chemical compound to be detected. In contrast hereto the first optical fiber element is, particularly preferred, devoid of the first material, thus, not comprising any amount of the first material.

Herein, the first material as comprised by the second optical fiber element is designed to undergo a conversion into a second material upon a chemical reaction with at least one chemical compound to be detected. Specifically, the first material may be comprised by the second cladding in a manner that the second core and, apart from the first material, the second cladding are not affected by the chemical compound to be detected but rather remain chemically stable with respect to the chemical compound. As a result, depending on a sensed property which is related to the conversion of the first material into the second material by the chemical compound, an initial optical signal introduced into the second optical fiber element is modified into at least one modified optical signal.

Further according to the present invention, the second optical fiber element is adapted to communicate with the first optical fiber element. Herein, the second optical fiber element may, specifically, be directed or indirectly located at one of the ends of the first optical fiber element. In order to achieve a direct coupling between the two individual optical fiber elements, the second optical fiber element may, preferably, be located at a facet of the first optical fiber element, wherein the term "facet" refers to a surface at an adjacent end of the optical fiber which is designed to couple in and/or couple out and/or reflect light of an optical signal. In a particular embodiment as described below in more detail, a Fabry-Perot interferometer may be obtained hereby. For a purpose of achieving the direct coupling, a splicing, in particular a fusion splicing, of the two individual optical fiber elements may be performed. As generally used, the terms "fusion splicing" or simply "splicing" refer to joining two adjacent ends of the two individual optical fiber elements by applying heat to the envisaged junction in order to provide a coupling which allows optical signals to pass between the two individual optical fiber elements with as little scattering and/or reflection as possible. After a stripping of the respective ends of the optical fiber elements, preferably, by removing a partition of a coating which surrounds the corresponding claddings, a cleaning of the bare optical fiber elements and a cleaving of the optical fiber element in order to obtain facets which are flat and perpendicular to each optical axis of the two optical fiber elements, an application of heat is, typically, used for melting and, concurrently, fusing the respective ends of the two optical fiber element together. However, other processes which are designed for joining the adjacent ends of the two individual optical fiber elements together may also be applicable. Alternatively, an indirect coupling between the two individual optical fiber elements may be achieved by placing an optical coupling element between adjacent ends of the first optical fiber element and of the second optical fiber element, in particular an optical resonator element. However, further kinds of optical coupling elements may, alternatively or in addition, also be feasible.

In a particularly preferred embodiment, a hollow core fiber element may be located between adjoining ends of the two individual optical fiber elements which may, in particular, be obtained by, firstly, splicing it to the first optical fiber element and by, subsequently, splicing the second optical fiber element to the hollow core fiber element. However, other kinds of manufacturing processes may also be employed. As generally used, the term "hollow core fiber" refers to a particular kind of optical fibers which comprises a hollow core that may be filled with a fluid, i.e. a gas, a liquid, particles, or a mixture, an aerosol, or a suspension thereof, in order to fulfil the condition of Equation (1). In a particular embodiment, the hollow core may be surrounded by a cladding having a micro-structured cladding region which may be adapted for guiding the optical signal through the hollow core by nonlinear optical effects. Since the hollow core fiber exhibits considerably higher propagation losses compared to solid-core fibers, the length of the hollow core fiber element may, preferably, be chosen as the diameter of the optical fiber or below.

In this particularly preferred embodiment, a combination of the hollow core fiber element and the second optical fiber element may be designed for a use as an optical resonator element, specifically, as a Fabry-Perot interferometer element. As generally used, the term "Fabry-Perot interferometer" refers to an optical resonator having two highly reflective surfaces, such as two highly reflecting mirrors, which may be arranged in a parallel manner with respect to each other. Since the facet of the first optical fiber elements adjoining the hollow core fiber element and the second end (facet) of the second optical fiber element may exhibit a sufficient reflectivity, a parallel arrangement of the adjacent facets may, thus, allow obtaining the desired interferometer. As illustrated below in more detail, experimental results have shown that using a hollow core fiber which may be used as a coupling element between the first optical fiber element and the second optical fiber element appears to be quite efficient.

As already indicated above, the second optical fiber element is designated, on one hand, to receive the at least one optical signal which is provided by the first optical fiber element and, on the other hand, to emit the at least one modified optical signal as generated in the second optical fiber element having sensing properties into the first optical fiber element. As a result, the first optical fiber element is designated to guide the at least one modified optical signal from its one end adjoining the second optical fiber element to its other end which directly or indirectly adjoins an evaluation device as further comprised by the optical detector. As used herein, the term "evaluation device" refers, in general, to an arbitrary device which is designed to determine at least one property which is related to the chemical compound by evaluating the at least one modified optical signal generated by the second optical fiber element and provided to the evaluation device via the first optical fiber element. Herein, the evaluation device may be or may comprise optical components and/or electronic components which may be suitable for this purpose. With regard to the optical components, the evaluation device may comprise an interrogation system, wherein the term "interrogation system" refers to an optical system designed to generate an optical signal by reading out the at least one optical fiber element being attached to the evaluation device. Specifically, the interrogation system may, therefore, comprise at least one optical source, at least one optical circulator, and at least one optical spectrum analyzer, which may, preferably, be integrated into a single equipment. However, other optical components and arrangements thereof may also be feasible.

With regard to the electronic components, the evaluation device may comprise one or more integrated circuits, such as one or more application-specific integrated circuits (ASICs), and/or one or more data processing devices, such as one or more computers, preferably one or more microcomputers and/or microcontrollers. Additional components may be comprised, such as one or more preprocessing devices and/or data acquisition devices, such as one or more devices for receiving and/or preprocessing of the sensor signals, such as one or more AD-converters and/or one or more filters. Further, the evaluation device may comprise one or more data storage devices. Further, the evaluation device may comprise one or more interfaces, such as one or more optical fiber elements or optical terminals which may be adapted to communicate with the first optical fiber element. The at least one evaluation device may, further, be adapted to perform at least one computer program, such as at least one computer program performing or supporting the step of generating the items of information. As an example, one or more algorithms may be implemented which, by using the sensor signals as input variables, may perform a predetermined transformation into the at least one property related to the chemical compound. For this purpose, the evaluation device can also be designed to completely or partly control or drive the detector, for example by the evaluation device being designed to control at least one light source being designated for providing the initial optical signals as described above. The evaluation device can be designed, in particular, to carry out at least one measurement cycle in which one or a plurality of initial optical signals are generated and one or a plurality of modified sensor signals are recorded, in particular, a plurality of successive sensor signals over at least one time interval.

As indicated above, a first material which is designated to be converted into a second material upon a chemical reaction with at least one chemical compound to be detected, is comprised by a partition of the second optical fiber element in order to modify the initial optical signal to at least one modified optical signal, depending on one or more properties related to a conversion of the first material into the second material by the chemical compound. For this purpose, the second optical fiber element comprises a polarization-maintaining optical fiber. As generally used, the term "polarization-maintaining optical fiber", which may also abbreviated to "PMF" or "PMF fiber", refers to a single-mode optical fiber which is designed to maintain the two polarization modes of linearly polarized light provided to the PMF fiber in an appropriate manner, specifically, by avoiding a cross-coupling of optical power between the two polarization modes. For this purpose, the PMF fiber may, preferably, exhibit a linear birefringence, allowing the two polarization modes to propagate along the PMF fiber with distinct phase velocities. Herein, the desired birefringence in the PMF fiber may be provided by using at least one stress rod located in the cladding of the PMF fiber. Known configurations of the at least one stress rod in the PMF fiber illustrated below in more detail are denoted as "Panda fiber" or "Bow-tie fiber". However, further configurations may also be applicable.

Accordingly, the first material is comprised by at least one stress rod located in the second cladding of the second optical fiber element whereas the first optical fiber element may, advantageously, be devoid of the first material and/or of any stress rod. Such a kind of arrangement allows, on one hand, providing the second optical fiber element having a sophisticated setup which may, as usual, be associated with higher effort and expenses whereas, on the other hand, the first optical fiber element may be provided as a simple, cost-effective single-fiber mode, preferably, without any specific modifications. Hereby, a length of the first optical fiber element may exceed the length of the second optical fiber element, preferably, by a factor of at least 100, in particular of at least 1000. By way of example, the first optical fiber element may exhibit a first length of 10 cm to 10 m, however, longer if required, for example, for remote sensing, specifically of 0.5 m to 2.5 m, whereas the second optical fiber element may exhibit a second length of 50 $\mu$m to 2000 $\mu$m, preferably of 100 $\mu$m to 500 $\mu$m, specifically of 200 $\mu$m to 300 $\mu$m. As a result, the overall optical detector may, on one hand, be sophisticated in order to be capable of detecting the desired at least one chemical compound but, on the other hand, for a reasonably-priced setup.

As described below in more detail, the first optical fiber element and the second optical fiber element may, in this preferred embodiment, be connected in a manner that the at least one optical signal may be guided from the first core of one of the first optical fiber element to at least one of the stress rods, preferably to exactly one of the stress rods, as, preferably, comprised by the second optical fiber element, or vice-versa. However, other kinds of couplings between the two optical fiber elements may also be feasible.

In a particularly preferred embodiment of the optical detector according to the present invention, the first material may be selected in order to allow its conversion into the second material upon contact with a chemical compound which is provided in a fluid state, specifically, as a gas, a liquid, as particles, or a mixture, an aerosol, or a suspension thereof, whereby the contact between the chemical compound and the first material to be at least partially converted into the second material may be facilitated.

As further indicated above, modern electrochemical energy devices, specifically electrochemical cells such as primary or secondary batteries, which are used for storing and/or providing electrical energy from chemical reactions, usually, comprise lithium as anode material, wherein the lithium may, typically, be provided in form of a lithium salt, specifically, selected from lithium hexafluorophosphate ($LiPF_6$), lithium perchlorate ($LiClO_4$), lithium tetrafluoroborate ($LiBF_4$), lithium tetrachloroaluminate ($LiAlCl_4$), lithium tetrachlorogallate ($LiGaCl_4$), or lithium bromide (LiBr). Since these and other salts are known to easily hydrolyze, a fluid product, specifically, hydrofluoric acid (HF), hydrochloric acid (HCl), or hydrobromic acid (HBr), may be generated, in particular, when moisture, especially in form of water molecules ($H_2O$), may be present in the electrochemical cell. Other lithium salts and further fluid products may, however, also be generated.

In a particularly preferred embodiment, the first material may, therefore, be designed in order to undergo the conversion into the second material upon contact with at least one of the above-described fluid product, specifically, with at least one of HF, HCl, or HBr, as the chemical compound. However, other kinds of chemical compounds which can react with the optical fiber, in particular with the cladding or a partition thereof, may also be feasible. Herein, the skilled person can easily select at least one substance for the first material which may be appropriate for this purpose. More particular, the first material may, thus, be or comprise a substance being sensitive to at least one of HF, HCl, or HBr, wherein this substance may, preferably, be selected from one or more of silica ($SiO_2$), calcium carbonate ($CaCO_3$), alumina ($Al_2O_3$), or aluminum oxide hydroxide (AlO(OH)), or a doped version thereof, such as germanium (Ge)-doped silica. However, other kinds of substances may also be feasible for this purpose.

As a result, the first material may be designated to be converted into the second material in a manner that the second material may exhibit a change in composition and/or volume compared to the first material. In particular, the second material may be a fluid and/or a volatile component, which may result in an observation that the first material may, at least partially, be dissolved by the chemical compound, whereby a partition of the first material may, at least partially, be removed from the second cladding of the second optical fiber element, specifically, from the stress rod, preferably, comprised by the second cladding of the second optical fiber element. As a consequence of the conversion of the first material into the second material, the at least initial optical signal which is received by the second core of the second optical fiber may experience a different composition and/or volume of the second cladding surrounding the second core of the second optical fiber, whereby the at least one modified optical signal is generated, depending on the conversion of the first material into the second material by the chemical compound. As a result, the at least one modified optical signal generated in the second optical fiber element and, subsequently, guided via the first optical fiber element to the evaluation device, thus, allows the evaluation device to determine at least one property related to the chemical compound by evaluating the at least one modified optical signal.

In a particularly preferred embodiment, the change in composition and/or volume of the first material may depend on an accumulated concentration of the chemical compound to be detected, preferably, of the fluid product generated in the electrochemical energy device, in particular, of at least one of HF, HCl, or HBr. Consequently, the evaluation device may, thus, be adapted not only to derive evidence of a presence of the chemical compound to be detected but may also be designated to determine the accumulated concentration of the chemical compound to be detected, preferably, of the fluid product in an environment in which the second optical fiber element may be located. Thus, locating the second optical fiber element in or at a electrochemical energy device, specifically, in an electrochemical cell such as a primary battery or a secondary battery, especially attaching at or integrating it in at least one partition of the electrochemical energy device, may allow determining the presence and/or the accumulated concentration of the chemical compound to be detected, preferably, of the fluid product generated in the electrochemical energy device, in particular, of at least one of HF, HCl, or HBr. As indicated above, the fluid products can be used as a reliable indicator for moisture, wherein the moisture can occur in the electrochemical energy device either as a result of a contamination during manufacturing of the electrochemical energy device or due to an imperfect sealing of the electrochemical energy device. In addition, the fluid product can also be formed in an abuse condition, in particular, where an electrolyte solvent may decompose into one or more kinds of alcohols, which may, subsequently, decompose into one or more lithium fluoro- or chloro-compounds, whereby at least one of the fluid products may, eventually, be obtained.

Further, in this manner it can also be determined whether or not the fluid product generated in the electrochemical energy device, in particular, at least one of HF, HCl, or HBr, may be consumed somewhere in the battery, wherein it may, however, be taken under consideration that, due to possible side-reactions, the optical signal can keep changing as long as the fluid product may not be consumed inside the electrochemical energy device. Further, it can, in a similar manner, be detected whether or not new fluid product may form at a later stage. By way of example, initially internal reactions, such as an initial formation of an solid-electrolyte interphase (SEI), may consume the fluid product, whereas later, in particular, as a result of an imperfect sealing of the electrochemical energy device or a partition thereof or due to a mechanical cell damaging, fresh fluid product may be formed.

In a further aspect, the present invention relates to a method for a detection of a chemical compound according to claim 10, by using an optical detector as defined in any one of claims 1 - 9. The method comprises the following steps a) to e):

a) providing an optical detector according to any one of the preceding claims;
b) guiding at least one optical signal along the first optical fiber element to the second optical fiber element;
c) bringing a first material comprised by at least a partition of the second optical fiber element into contact with at least one chemical compound to be detected, whereupon the first material is converted into a second material upon a chemical reaction with the chemical compound; whereby at least one modified optical signal is generated depending on a conversion of the first material into the second material by the chemical compound;
d) guiding the at least one modified optical signal along the first optical fiber element to an evaluation device; and
e) determining at least one property related to the chemical compound by evaluating the at least one modified optical signal in the evaluation device.

Herein, the indicated steps may, preferably, be performed in the given order, commencing with step a) and finishing with step e). However, any or all of the indicated steps may also be repeated several times and/or performed concurrently in part.

According to step a), an optical detector as described elsewhere in this document is provided, wherein, according to step b), at least one optical signal is provided in order to be guided along the first optical fiber element to the second optical fiber element.

According to step c), a first material as comprised by at least one partition of the second optical fiber element, specifically, by at least one stress rod comprised by at least a partition of the second cladding surrounding the second core of second optical fiber element, is brought into contact with at least one chemical compound to be detected. As a result, the first material is converted into a second material upon a chemical reaction with the chemical compound in a manner that at least one modified optical signal is generated, depending on a conversion of the first material into the second material by the chemical compound.

According to step d), the at least one modified optical signal along the first optical fiber element to the evaluation device, wherein, according to step e), at least one property related to the chemical compound is determined by evaluating the at least one modified optical signal in the evaluation device. In step e), evidence of a presence of the chemical compound to be detected may be derived and/or an accumulated concentration of the chemical compound to be detected may, preferably, be determined.

For further details concerning the method, reference may be made to the description of the optical detector.

In a further aspect, the present invention relates to an electrochemical energy device, also denominated as electrochemical cell, such as a primary battery or a secondary battery, specifically a rechargeable Li-ion battery, a supercapacitor or a fuel cell, which comprises the optical detector as defined in the appended claims, wherein the second optical fiber element may be located in or at the electrochemical energy device, specifically, in an electrochemical cell such as a primary battery or a secondary battery, especially attaching at or integrating it in at least one partition of the electrochemical energy device, whereby a presence and/or an accumulated concentration of the chemical compound to be detected, preferably, of the fluid product generated in the electrochemical energy device, in particular, of at least one of HF, HCl, or HBr, can be determined.

The term "electrochemical energy device", which may also be denoted by the term "electrochemical cell", may, particularly, be used for storing and providing electrical energy from chemical reactions which are performed within the electrochemical device. For this purpose, the electrochemical device comprises at least one first half-cell comprising at least one positive electrode and at least one second half-cell comprising at least one negative electrode, wherein the two half-cells are separated from each other in order to avoid a short circuit. In the electrochemical cells addressed here,

8

the half-cells are, thus, separated by an additional material which is, generally, denoted as separator placed between the at least one positive electrode and the at least one negative electrode. However, in order to simultaneously provide a path between the two different types of the electrodes, in particular for a transport of ions, generally, at least one electrolyte is used. In order to be particularly suited for this purpose, the separator can, thus, advantageously take a form of a membrane which may exhibit a porous composition being adapted for both receiving and providing the electrolyte and enabling the transport of the ions between the two different types of the electrodes.

In general, the optical detector can be placed at any location within the electrochemical energy device, on particular within the electrochemical cell, as long as they the selected location allows a contact with the chemical compound to be detected, wherein a location which may exhibit a higher temperature compared to other locations may be preferred since it may be more promising to detect there the desired chemical compound, such as HF. Preferably, the optical detector specifically designed for HF sensing can be placed at the at least one separator, which appears to be the most flexible location for sensing different properties. However, integrating the optical detector into an electrode may be an alternative. Herein, a position near a tab inside the electrode may be most preferred. A further alternative may comprise a positioning of the optical detector above the electrodes in a free volume which may, for example, be available in a prismatic cell. Further, placing at least two individual optical detectors at different positions may also be interesting.

Summarizing, an optical detector is proposed, which allows detecting at least one chemical compound, in particular, a fluid product generated in an electrochemical energy device, specifically, at least one of HF, HCl, or HBr, wherein the optical detector comprises a first optical fiber element adapted for performing a first function of an optical waveguide, a second optical fiber element designed for a performing a second function of measuring at least one modified property the second optical fiber element, and an evaluation device designated for determining a presence and/or an accumulated concentration of the chemical compound to be detected. Advantageously, the optical detector can be used for a *real-time* detection of the chemical compound, preferably, in an *in situ* and/or an *in operando* manner.

Short description of the Figures

Further optional features and embodiments of the invention will be disclosed in more detail in the subsequent description of preferred embodiments, preferably in conjunction with the dependent claims. Therein, the respective optional features may be realized in an isolated fashion as well as in any arbitrary feasible combination, as the skilled person will realize. It is emphasized here that the scope of the invention is not restricted by the preferred embodiments. In the Figures:

| | |
|---|---|
| Figure 1 | illustrates an aerial view of a first preferred embodiment of an optical detector according to the present invention, comprising a first optical fiber element, a second optical fiber element, and an evaluation device; |
| Figures 2a to 2c | illustrate cross-sectional views of preferred embodiments of the first optical fiber element (Figure 2a) and the second optical fiber element (Figures 2b and 2c), respectively, the optical detector according to the present invention; |
| Figures 3a to 3d | illustrate microscopic images of a treatment of the second optical fiber element after being immersed in an electrolyte, wherein various amounts of water ($H_2O$) have been added to the electrolyte in order to trigger a generation of HF: 0 ppm (Figure 3a), 500 ppm (Figure 3b), 2000 ppm (Figure 3c), 5000 ppm (Figure 3d); and |
| Figures 4a and 4b | illustrate an aerial view (Figure 4a) and a microscopic image (Figure 4b), respectively, of a second preferred embodiment of the optical detector according to the present invention. |

Detailed description of the embodiments

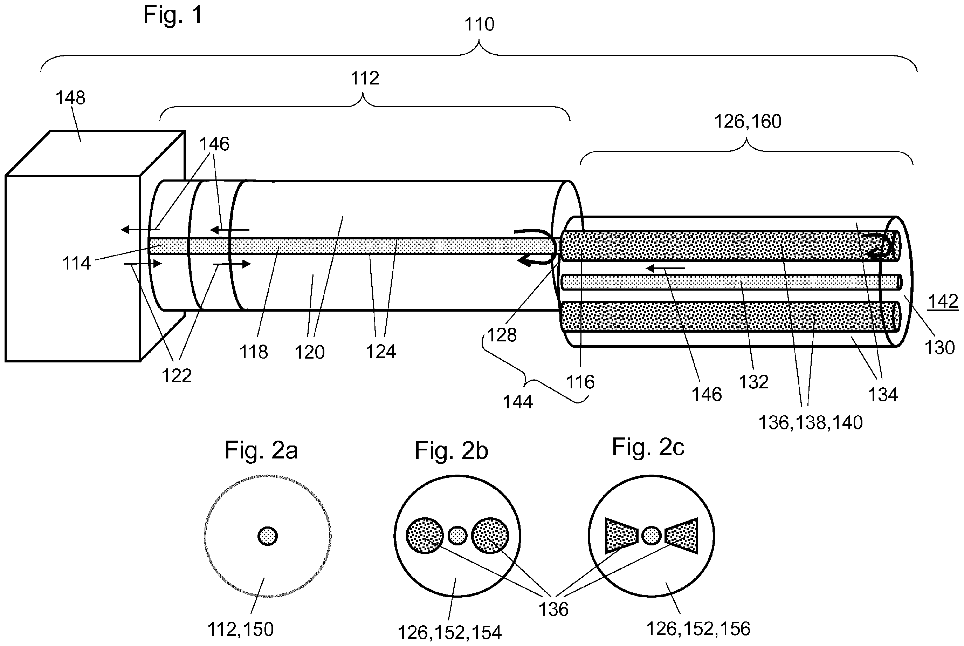

Figure 1 illustrates an aerial view of a first preferred embodiment of an optical detector 110 according to the present invention. Herein, the optical detector 110 comprises a first optical fiber element 112 having a first end 114, a second end 116, a solid first core 118 of an optical transparent material having a first refraction index $n_1$, and a first cladding 120 surrounding the first core 118 of the first optical fiber element 112 and having a second refraction index $n_2$, wherein the refraction indices $n_1$, $n_2$ fulfil a condition as expressed by the Equation (1) that

$$n_2 < n_1. \qquad\qquad (1)$$

As a result, an optical signal 122 introduced at the first end 114 into the first core 118 of the first optical fiber element can be guided with very low propagation losses along a course of the first core 118 by total internal reflection of the optical signal at adjacent walls 124 of the first cladding 120 surrounding the first core 118 to the second end 116, or vice-versa.

Further, the optical detector 110 comprises a second optical fiber element 126, preferably formed as a PMF fiber, having a first end 128, a second end 130, a solid second core 132 of an optical transparent material having a first refraction index $n_1$, and a second cladding 134 surrounding the second core 132 of the second optical fiber element 126, having a second refraction index $n_2$, wherein the refraction indices $n_1$, $n_2$ fulfil a condition as expressed by Equation (1) above, and a two individual stress rods 136, each of which comprises a first material 138 which is adapted to be converted into a second material 140 upon a chemical reaction with at least one chemical compound 142 to be detected by using the optical detector 110. However, a different number of stress rods 136, such as one, three, four, five, six or more stress rods 136, may also be feasible.

Herein, the second optical fiber element 126 is adapted to communicate with the first optical fiber element 112. For this purpose, the first end 128 of the second optical fiber element 126 and the second end 116 of the first optical fiber element 112 are, as schematically illustrated in Figure 1, directly coupled at a junction 144 with respect to each other. Herein, the first optical fiber element 112 and the second optical fiber element 126 are connected in a manner that the optical signal 122 can be guided from the first core 118 of first optical fiber element 112 to at least one of the stress rods 136 of the second optical fiber element 126, or vice-versa. Preferably, a splicing, in particular a fusion splicing, of the two individual optical fiber elements 112, 126 may be performed at the junction 144, whereby heat may be applied to the envisaged junction 144 in order to allow the optical signals 122 to pass between the two individual optical fiber elements 112, 126 with as little scattering as possible.

As a result of the coupling between the two individual optical fiber elements 112, 126, the second optical fiber element 126 is designed to receive the at least one optical signal 122 as provided by the first optical fiber element 112 and to generate and emit at least one modified optical signal 146 to the first optical fiber element 112. As described above and/or below in more detail, the at least one modified optical signal 146 depends on a conversion of the first material 138 into the second material 140 by contact of the first material 138 with the chemical compound 142.

Further, the optical detector 110 comprises an evaluation device 148 which is adapted to receive the at least one modified optical signal 146 as generated in the second optical fiber element 126, emitted by the second optical fiber element 126, received by the first optical fiber element 112 and guided along the first core 118 of the first optical fiber element 112 to the evaluation device 148. As schematically depicted in Figure 1, the first optical fiber element 112 may, preferably, be directly connected to the evaluation device 148, such as by a similar coupling as between the two individual optical fiber elements 112, 126, specifically, in order to minimize any losses at the signal transition from the first optical fiber element 112 to the evaluation device 148. However, other kinds of couplings between the first optical fiber element 112 and the evaluation device 148 may also be feasible.

Further according to the present invention, the evaluation device 148 is adapted to determine at least one property related to the chemical compound 142 by evaluating the at least one modified optical signal 146 which is provided to the evaluation device 148, preferably, in the above-described manner as schematically depicted in Figure 1. Moreover, the evaluation device 148 may also be designated to provide the at least one initial optical signal 122 and to compare the at least one modified optical signal 146 with the at least one initial optical signal 122 for evaluation purposes.

As illustrated in Figure 1, the second optical fiber element 126 differs from the first optical fiber element 112 by a presence of at least one, preferably two, possibly three, four, five, six or more stress rods 136 each of which comprises a first material 138 which is adapted to be converted into a second material 140 upon a chemical reaction with at least one chemical compound 142 to be detected by using the optical detector 110. This difference is schematically depicted in Figure 2. Herein, Figure 2a shows a cross-sectional view of a particularly preferred embodiment of the first optical fiber element 112 in a single-mode fiber 150.

In contrast hereto, Figures 2b and 2c schematically illustrate two different cross-sectional views of two preferred embodiments of the second optical fiber element 126 in form of PMF fibers 152 each of which comprises two individual stress rods 136. Accordingly, Figure 2b displays a so-called Panda fiber arrangement 154 while Figure 2c shows a so-called Bow-tie fiber arrangement 156 of the two individual stress rods 136. However, other arrangements of one or more individual stress rods 136 not depicted here may also be feasible.

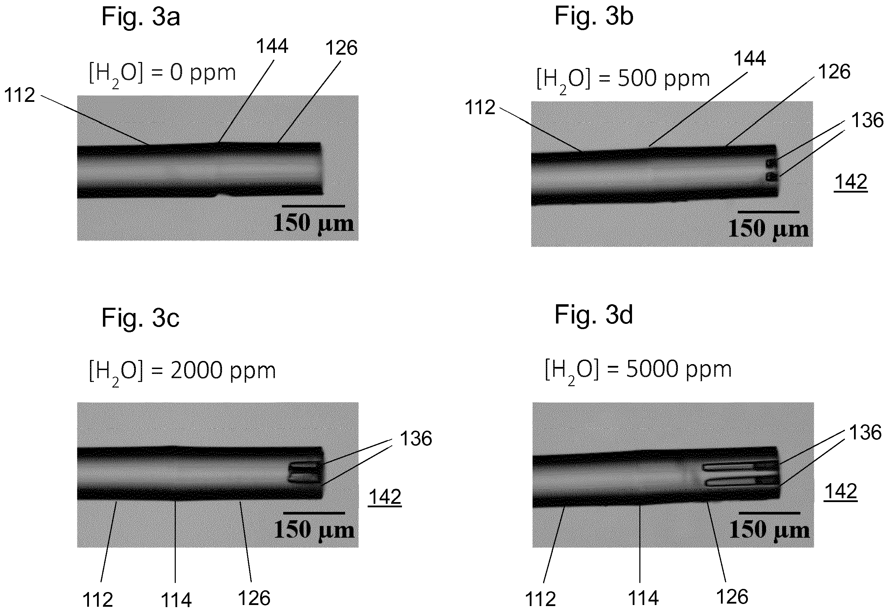

In a particularly preferred embodiment, a chemical reactivity of silica ($SiO_2$) towards hydrofluoric acid (HF), in particular, an enhanced chemical reactivity of stressed silica, specifically boron-doped silica or Ge-doped silica, towards HF, can be employed. However, other kinds of chemical compounds which can react with the second optical fiber element 126, in particular with the second cladding 134 or a partition thereof, may also be feasible. As can be derived from the microscopic images of Figure 3a compared to Figures 3b to 3d, the two individual stress rods 136 of the second optical fiber element 126 which is formed here as a polarization-maintaining optical fiber or - in abbreviated form - as a PMF fiber, slowly start dissolving in presence of small amounts of HF, whereas neither the second core 132 (although not visible in these microscopic images) nor the second cladding 134 of the second optical fiber element 126 corrode. Herein, the microscopic pictures of Figures 3a to 3d are taken after 12 days of application of the electrolyte LP30, comprising 1 M LiPF$_6$ in EC/DMC (50:50) v/v, into which the indicated amounts of H$_2$O have, intentionally, been added in order to trigger the generation of HF as the desired chemical compound to be detected by using the optical detector 110.

In the exemplary embodiments of Figures 3b to 3d, a corrosion of the two individual stress rods 136 comprising the boron-doped silica or the Ge-doped silica has been induced by applying moisture in form of a small amount of water (H$_2$O), in particular of 500 ppm in the example of Figure 3b, of 2000 ppm in the example of Figure 3c, and of 5000 ppm in the example of Figure 3d, respectively, which has been added to the lithium salt lithium hexafluorophosphate (LiPF$_6$) which is, typically, used in electrochemical cells. As a result, it has been observed that HF can be generated during this process. For further details concerning the generation of HF, reference may be made, e.g., to A. Guéguen, D. Streich, M. He, M. Mendez, F.F. Chesneau, P. Novak, and E.J. Berg, Decomposition of LiPF6 in high energy lithium-ion batteries studied with online electrochemical mass spectrometry, J. Electrochem. Soc. 163, A1095-A1100, 2016, wherein several reaction mechanisms for this particular process have been presented.

Irrespectively by which process HF has, eventually, been generated, the HF is capable of slowly entering a chemical reaction with the silica (SiO$_2$) available in solid form in any one of the stress rods 136 in the second optical fiber element 126 of Figure 3a. Herein the reaction can be summarized according to Equation (2):

$$SiO_2 + 2\,HF \rightarrow 2\,H_2O + SiF_4, \qquad (2)$$

whereby silicon tetrafluoride (SiF$_4$) may be formed, which constitutes a gaseous compound above 187 K, specifically, at room temperature. As a result, solid silica as the first material 138 upon reaction with fluid HF as the chemical compound 142 to be detected is converted into the gaseous compound silicon tetrafluoride, whereby, as depicted in Figures 3b to 3d, the stress rods 136 are more and more corroded and dissolved, thus, diminishing the length of the stress rods 136 involved in this procedure. Herein, the skilled person can conceive further examples for the first material which may function in a similar manner.

Moreover, a more detailed comparison of Figures 3b to 3d in which the corresponding second optical fiber element 126 has been treated with increasing amounts of HF reveals that the resulting conversion of the first material 138 into the second material 140 shows a clear dependency on the amount of HF available or the chemical reaction according to Equation (2). As a result, it may be possible to use the evaluation device 148 not only for deriving evidence of a presence of the chemical compound to be detected but may also be designated to determine an accumulated concentration of the chemical compound to be detected, i.e. HF in this exemplary embodiment.

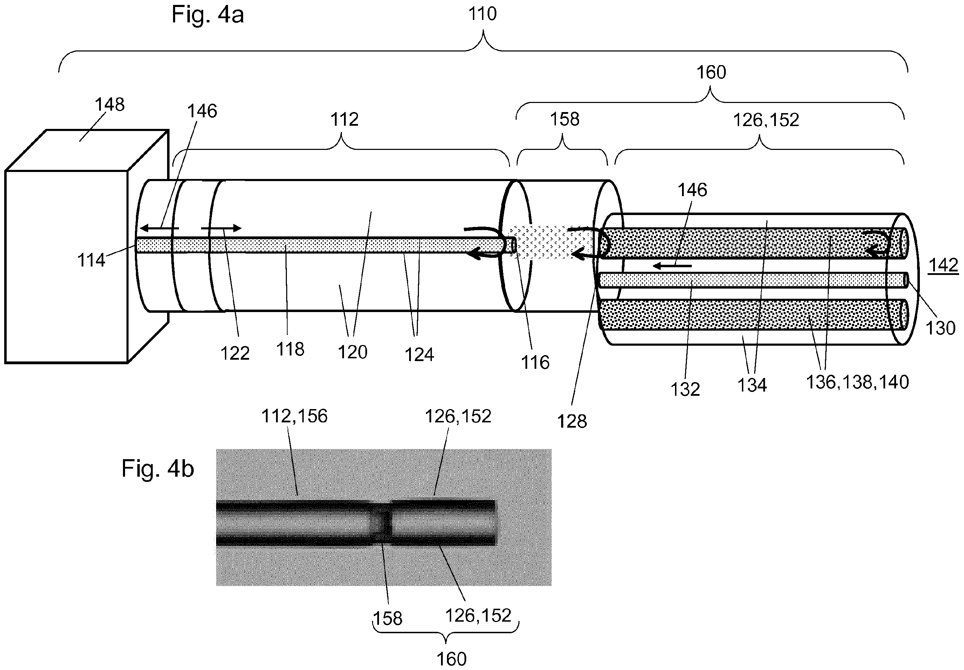

Figure 4a illustrates an aerial view while Figure 4b shows a microscopic image, respectively, of a second preferred embodiment of the optical detector 110 according to the present invention. In contrast to the implementation of the optical detector 110 as shown in Figures 1 to 3d, a hollow core fiber 158 is located between the first optical fiber element 112 which is provided here in a single-mode fiber 150 and the second optical fiber element 126, provided here in a PMF fiber arrangement 156. As a result, a Fabry-Perot (FP) interferometer element 160 comprising the hollow core fiber 158 and the second optical fiber element 126 is obtained. When a partition of the second optical fiber element 126 dissolves following a reaction with HF, a resonator length of the interferometer 160 may, thus, be reduced, leading to a change in the modified optical signal 146, which can be used for determining the amount of HF present at the environment in which the second optical fiber element 126 is located, in particular, in a electrochemical energy device.

List of Reference Numbers

**[0066]**

110    optical detector
112    first optical fiber element
114    first end
116    second end
118    (solid) first core
120    first cladding
122    (initial) optical signal
124    wall
126    second optical fiber element
128    first end
130    second end
132    (solid) second core
134    second cladding
136    stress rod

138    first material
140    second material
142    chemical compound
144    junction
146    modified optical signal
148    evaluation device
150    single-mode fiber
152    PMF fiber
154    Panda fiber arrangement
156    Bow-tie fiber arrangement
158    hollow core fiber
160    Fabry-Perot interferometer element


**Claims**

1. An optical detector (110) for a detection of a chemical compound (142), the optical detector (110) comprising

   - a first optical fiber element (112), wherein the first optical fiber element (112) is designed to guide at least one optical signal (122) and at least one modified optical signal (146);
   - a second optical fiber element (126), wherein the second optical fiber element (126) is adapted to communicate with the first optical fiber element (112), wherein the second optical fiber element (126) is designed to receive the at least one optical signal (122) provided by the first optical fiber element (112) and to emit the at least one modified optical signal (146) to the first optical fiber element (112), wherein the second optical fiber element (126) has a core (132) and a cladding (134), wherein the cladding (134) surrounds the core (132), wherein a partition of the second optical fiber element (126) comprises a first material (138) which is adapted to be at least partially converted into a second material (140) upon a chemical reaction with at least one chemical compound (142) to be detected, wherein the core (132) is chemically stable with respect to the at least one chemical compound (142), wherein the first material (138) is comprised by the cladding (134), wherein the first material (138) is designated to be converted into the second material (140) in a manner that the second material (140) exhibits a change in volume compared to the first material (138), wherein the at least one modified optical signal (146) depends on a conversion of the first material (138) into the second material (140) by the chemical compound (142); and
   - an evaluation device (148), wherein the evaluation device (148) is adapted to determine at least one property related to the chemical compound (142) by evaluating the at least one modified optical signal (146) provided to the evaluation device (148) by the first optical fiber element (112);

   wherein
   the at least one optical signal (122) which is received by the second optical fiber element (126) experiences a different volume of the cladding (134) surrounding the core (132) of the second optical fiber element (126), whereby the at least one modified optical signal (146) is generated, depending on the conversion of the first material (138) into the second material (140) by the chemical compound (142),
   **characterized in that**
   the second optical fiber element is or comprises a single-mode fiber, wherein, apart from the first material (138), the cladding (134) is chemically stable with respect to the at least one chemical compound (142),
   and **in that**
   the second optical fiber element (126) comprises a polarization-maintaining optical fiber (152) comprising at least one stress rod (136), wherein the first material (138) is comprised by the at least one stress rod (136) located in the cladding (134) of the polarization-maintaining optical fiber (152).

2. The optical detector (110) according to the preceding claim, wherein the first optical fiber element (112) is or comprises a single-mode fiber having a first core (118) and a first cladding (120), wherein the first cladding (120) surrounds the first core (118), wherein the first optical fiber element (112) is devoid of the first material (138).

3. The optical detector (110) according to any of the preceding claims, wherein the first optical fiber element (112) and the second optical fiber element (126) are connected in a manner that the at least one optical signal (122) is guidable from the first core (118) of first optical fiber element (112) to at least one of the stress rods (136) of the second optical fiber element (126), or vice-versa.

**4.** The optical detector (110) according to any one of the preceding claims, wherein the first material (138) is adapted to be converted into the second material (140) upon contact with a chemical compound (142) comprising a fluid, wherein the fluid is selected from at least one of a gas, a liquid, particles, or a mixture, an aerosol, or a suspension thereof.

**5.** The optical detector (110) according to the preceding claim, wherein the first material (138) is selected from at least one of silica ($SiO_2$), calcium carbonate ($CaCO_3$), alumina ($Al_2O_3$), aluminum oxide hydroxide ($AlO(OH)$), or a doped version thereof, wherein the first material (138) is adapted to be converted into the second material (140) upon contact with at least one of hydrofluoric acid (HF), hydrochloric acid (HCl), or hydrobromic acid (HBr) as the chemical compound (142).

**6.** The optical detector (110) according to any one of the preceding claims, wherein the first material (138) is adapted to be converted into the second material (140) in a manner that the first material (138) is at least partially dissolved by the chemical compound (142), thereby at least partially being removed from the second optical fiber element (126).

**7.** The optical detector (110) according to any one of the preceding claims, wherein the second optical fiber element (126) is located at a facet of the first optical fiber element (112).

**8.** The optical detector (110) according to any one of the preceding claims, wherein a hollow core fiber element (158) is located between the first optical fiber element (126) and the second optical fiber element (126), wherein a combination of the hollow core fiber element (158) and the second optical fiber element (126) is arranged as a Fabry-Perot interferometer element (160).

**9.** The optical detector (110) according to the preceding claim, wherein the first material (138) is adapted to be converted into the second material (140) in a manner that the combination of the hollow core fiber element (158) and the second optical fiber element (126) being adapted to function as the Fabry-Perot interferometer element (160) is designed to change its resonator length.

**10.** A method for a detection of a chemical compound (142), the method comprising the following steps:

a) providing an optical detector (110) according to any one of the preceding claims;
b) guiding at least one optical signal (122) along the first optical fiber element (112) to the second optical fiber element (126);
c) bringing a first material (138) comprised by a partition of the second optical fiber element (126) into contact with at least one chemical compound (142) to be detected, whereupon the first material (138) is converted into a second material (140) upon a chemical reaction with the chemical compound (142); whereby at least one modified optical signal (146) is generated depending on a conversion of the first material (138) into the second material (140) by the chemical compound (142);
d) guiding the at least one modified optical signal (146) along the first optical fiber element (112) to an evaluation device (148); and
e) determining at least one property related to the chemical compound (142) by evaluating the at least one modified optical signal (146) in the evaluation device (148).

**11.** The method according to the preceding claim, wherein evidence of a presence of the chemical compound (142) to be detected is derived and/or wherein an accumulated concentration of the chemical compound (142) to be detected is determined in step e).

**12.** An electrochemical energy device comprising at least one optical detector (110) according to any of the preceding claims referring to the optical detector (110), wherein the optical detector (110) is attached to or integrated into at least one partition of the electrochemical energy device.

**13.** The electrochemical energy device according to the preceding claim, wherein the optical detector is attached to or integrated into at least one of a separator or an electrode comprised by the electrochemical energy device.

**Patentansprüche**

**1.** Optischer Detektor (110) zum Nachweis einer chemischen Verbindung (142), wobei der optische Detektor (110) umfasst:

- ein erstes Lichtleiterfaserelement (112), wobei das erste Lichtleiterfaserelement (112) eingerichtet ist, um mindestens ein optisches Signal (122) und mindestens ein modifiziertes optisches Signal (146) zu führen;
- ein zweites Lichtleiterfaserelement (126), wobei das zweite Lichtleiterfaserelement (126) geeignet ist, um mit dem ersten Lichtleiterfaserelement (112) zu kommunizieren, wobei das zweite Lichtleiterfaserelement (126) eingerichtet ist, um das mindestens eine optische Signal (122) zu empfangen, das durch das erste Lichtleiterfaserelement (112) bereitgestellt wird, und um das mindestens eine modifizierte optische Signal (146) an das erste Lichtleiterfaserelement (112) zu emittieren, wobei das zweite Lichtleiterfaserelement (126) einen Kern (132) und eine Ummantelung (134) aufweist, wobei die Ummantelung (134) den Kern (132) umgibt, wobei ein Teilbereich des zweiten Lichtleiterfaserelements (126) ein erstes Material (138) umfasst, das geeignet ist, um bei einer chemischen Reaktion mit mindestens einer nachzuweisenden chemischen Verbindung (142) mindestens teilweise in ein zweites Material (140) umgewandelt zu werden, wobei der Kern (132) in Bezug auf die mindestens eine chemische Verbindung (142) chemisch stabil ist, wobei das erste Material (138) durch die Ummantelung (134) gebildet wird, wobei das erste Material (138) konzipiert ist, um in einer Weise in das zweite Material (140) umgewandelt zu werden, dass das zweite Material (140), verglichen mit dem ersten Material (138), eine Änderung des Volumens zeigt, wobei das mindestens eine modifizierte optische Signal (146) von einer Umwandlung des ersten Materials (138) in das zweite Material (140) durch die chemische Verbindung (142) abhängig ist; und
- eine Auswertungsvorrichtung (148), wobei die Auswertungsvorrichtung (148) geeignet ist, um mindestens eine Eigenschaft zu bestimmen, die mit der chemischen Verbindung (142) zusammenhängt, indem das mindestens eine modifizierte optische Signal (146), das der Auswertungsvorrichtung (148) durch das erste Lichtleiterfaserelement (112) bereitgestellt wird, ausgewertet wird;

wobei das mindestens eine optische Signal (122), das von dem zweiten Lichtleiterfaserelement (126) empfangen wird, ein anderes Volumen der Ummantelung (134) erfährt, welche den Kern (132) des zweiten Lichtleiterfaserelements (126) umgibt, wodurch das mindestens eine modifizierte optische Signal (146) generiert wird, das von der Umwandlung des ersten Materials (138) in das zweite Material (140) mittels der chemischen Verbindung (142) abhängig ist, **dadurch gekennzeichnet, dass** das zweite Lichtleiterfaserelement eine Einmodenfaser ist oder umfasst, wobei, abgesehen von dem ersten Material (138), die Ummantelung (134) in Bezug auf die mindestens eine chemische Verbindung (142) chemisch stabil ist, und das zweite Lichtleiterfaserelement (126) eine polarisationserhaltende Lichtleiterfaser (152) umfasst, die mindestens einen Belastungsstab (136) umfasst, wobei das erste Material (138) von dem mindestens einen Belastungsstab (136), der sich in der Ummantelung (134) der polarisationserhaltenden Lichtleiterfaser (152) befindet, umfasst ist.

2. Optischer Detektor (110) nach dem vorhergehenden Anspruch, wobei das erste Lichtleiterfaserelement (112) eine Einmodenfaser mit einem ersten Kern (118) und einer ersten Ummantelung (120) ist oder umfasst, wobei die erste Ummantelung (120) den ersten Kern (118) umgibt, wobei das erste Lichtleiterfaserelement (112) frei von dem ersten Material (138) ist.

3. Optischer Detektor (110) nach einem der vorhergehenden Ansprüche, wobei das erste Lichtleiterfaserelement (112) und das zweite Lichtleiterfaserelement (126) in einer Weise verbunden sind, dass das mindestens eine optische Signal (122) von dem ersten Kern (118) des ersten Lichtleiterfaserelements (112) zu mindestens einem der Belastungsstäbe (136) des zweiten Lichtleiterfaserelements (126) führbar ist, oder in umgekehrter Richtung.

4. Optischer Detektor (110) nach einem der vorhergehenden Ansprüche, wobei das erste Material (138) geeignet ist, um bei Kontakt mit einer chemischen Verbindung (142), die ein Fluid umfasst, in das zweite Material (140) umgewandelt zu werden, wobei das Fluid ausgewählt aus mindestens einem von einem Gas, einer Flüssigkeit, Partikeln oder einer Mischung, einem Aerosol oder einer Suspension hiervon.

5. Optischer Detektor (110) nach dem vorhergehenden Anspruch, wobei das erste Material (138) ausgewählt ist aus mindestens einem von Siliziumdioxid ($SiO_2$), Calciumcarbonat ($CaCO_3$), Aluminiumoxid ($Al_2O_3$), Aluminiumoxidhydroxid ($AlO(OH)$) oder einer dotierten Variante davon, wobei das erste Material (138) geeignet ist, um bei Kontakt mit mindestens einer von Fluorwasserstoffsäure (HF), Salzsäure (HCl) oder Bromwasserstoffsäure (HBr) als die chemische Verbindung (142) in das zweite Material (140) umgewandelt zu werden.

6. Optischer Detektor (110) nach einem der vorhergehenden Ansprüche, wobei das erste Material (138) geeignet ist, um in einer Weise in das zweite Material (140) umgewandelt zu werden, dass das erste Material (138) mindestens teilweise durch die chemische Verbindung (142) gelöst wird, wodurch es zumindest teilweise aus dem zweiten Lichtleiterfaserelement (126) entfernt wird.

7. Optischer Detektor (110) nach einem der vorhergehenden Ansprüche, wobei das zweite Lichtleiterfaserelement (126) sich an einer Facette des ersten optischen Faserelements (112) befindet.

8. Optischer Detektor (110) nach einem der vorhergehenden Ansprüche, wobei sich ein Hohlkernfaserelement (158) zwischen dem ersten Lichtleiterfaserelement (126) und dem zweiten Lichtleiterfaserelement (126) befindet, und wobei eine Kombination des Hohlkernfaserelements (158) und des zweiten Lichtleiterfaserelements (126) als Fabry-Perot Interferometerelement (160) angeordnet ist.

9. Optischer Detektor (110) nach dem vorhergehenden Anspruch, wobei das erste Material (138) geeignet ist, um in einer Weise in das zweite Material (140) umgewandelt zu werden, dass die Kombination des Hohlkernfaserelements (158) und des zweiten Lichtleiterfaserelements (126), die geeignet ist, um als das Fabry-Perot-Interferometerelement (160) zu fungieren, dazu eingerichtet ist, um dessen Resonatorlänge zu verändern.

10. Verfahren zum Nachweisen einer chemischen Verbindung (142), wobei das Verfahren die folgenden Schritte umfasst:

a) Bereitstellen eines optischen Detektors (110) nach einem der vorhergehenden Ansprüche;
b) Führen mindestens eines optischen Signals (122) entlang des ersten Lichtleiterfaserelements (112) zu dem zweiten Lichtleiterfaserelement (126);
c) Inkontaktbringen eines ersten Materials (138), das von einem Teilbereich des zweiten Lichtleiterfaserelements (126) umfasst ist, mit mindestens einer nachzuweisenden chemischen Verbindung (142), woraufhin das erste Material (138) bei einer chemischen Reaktion mit der chemischen Verbindung (142) in ein zweites Material (140) umgewandelt wird; wodurch mindestens ein modifiziertes optisches Signal (146) erzeugt wird in Abhängigkeit von einer Umwandlung des ersten Materials (138) in das zweite Material (140) durch die chemische Verbindung (142);
d) Führen des mindestens einen modifizierten optischen Signals (146) entlang des ersten Lichtleiterfaserelements (112) zu einer Auswertungsvorrichtung (148); und
e) Bestimmen mindestens einer Eigenschaft, die mit der chemischen Verbindung (142) zusammenhängt, durch Auswerten des mindestens einen modifizierten optischen Signals (146) in der Auswertungsvorrichtung (148).

11. Verfahren nach dem vorhergehenden Anspruch, wobei ein Nachweis einer Anwesenheit der nachzuweisenden chemischen Verbindung (142) abgeleitet wird und/oder wobei eine akkumulierte Konzentration der nachzuweisenden chemischen Verbindung (142) in Schritt e) bestimmt wird.

12. Elektrochemische Energievorrichtung, die mindestens einen optischen Detektor (110) nach einem der vorhergehenden Ansprüche, die sich auf den optischen Detektor (110) beziehen, umfasst, wobei der optische Detektor (110) an mindestens einem Teilbereich der elektrochemischen Energievorrichtung angebracht oder darin integriert ist.

13. Elektrochemische Energievorrichtung nach dem vorhergehenden Anspruch, wobei der optische Detektor an mindestens einem von einem Separator oder einer Elektrode angebracht oder darin integriert ist, der/die von der elektrochemischen Energievorrichtung umfasst ist.

**Revendications**

1. Détecteur optique (110) pour une détection d'un composé chimique (142), le détecteur optique (110) comprenant

- un premier élément à fibre optique (112), dans lequel le premier élément à fibre optique (112) est conçu pour guider au moins un signal optique (122) et au moins un signal optique modifié (146) ;
- un second élément à fibre optique (126), dans lequel le second élément à fibre optique (126) est adapté pour communiquer avec le premier élément à fibre optique (112), dans lequel le second élément à fibre optique (126) est conçu pour recevoir l'au moins un signal optique (122) fourni par le premier élément à fibre optique (112) et pour émettre l'au moins un signal optique modifié (146) au premier élément à fibre optique (112), dans lequel le second élément à fibre optique (126) a une âme (132) et une gaine (134), dans lequel la gaine (134) entoure l'âme (132), dans lequel une partie du second élément à fibre optique (126) comprend un premier matériau (138) qui est adapté pour être au moins partiellement converti en un second matériau (140) lors d'une réaction chimique avec au moins un composé chimique (142) destiné à être détecté, dans lequel l'âme (132) est chimiquement stable par rapport à l'au moins un composé chimique (142), dans lequel le premier matériau (138) est compris par la gaine (134), dans lequel le premier matériau (138) est désigné pour être converti en le second matériau (140) de manière telle que le second matériau (140) présente un changement de volume par comparaison avec le premier matériau (138), dans lequel l'au moins un signal optique modifié (146) dépend d'une conversion du premier matériau (138) en le second matériau (140) par le composé chimique (142) ; et
- un dispositif d'évaluation (148), dans lequel le dispositif d'évaluation (148) est adapté pour déterminer au moins une propriété connexe au composé chimique (142) en évaluant l'au moins un signal optique modifié (146) fourni au dispositif d'évaluation (148) par le premier élément à fibre optique (112) ;

dans lequel l'au moins un signal optique (122) qui est reçu par le second élément à fibre optique (126) subit un différent volume de la gaine (134) entourant l'âme (132) du second élément à fibre optique (126), moyennant quoi l'au moins un signal optique modifié (146) est généré, en fonction de la conversion du premier matériau (138) en le second matériau (140) par le composé chimique (142),
**caractérisé en ce que** le second élément à fibre optique est ou comprend une fibre monomodale, dans lequel, à part le premier matériau (138), la gaine (134) est chimiquement stable par rapport à l'au moins un composé chimique (142),
et **en ce que** le second élément à fibre optique (126) comprend une fibre optique de maintien de polarisation (152) comprenant au moins une tige de contrainte (136), dans lequel le premier matériau (138) est compris par l'au moins une tige de contrainte (136) située dans la gaine (134) de la fibre optique de maintien de polarisation (152) .

2. Détecteur optique (110) selon la revendication précédente, dans lequel le premier élément à fibre optique (112) est ou comprend une fibre monomodale ayant une première âme (118) et une première gaine (120), dans lequel la première gaine (120) entoure la première âme (118), dans lequel le premier élément à fibre optique (112) est dépourvu du premier matériau (138).

3. Détecteur optique (110) selon l'une quelconque des revendications précédentes, dans lequel le premier élément à fibre optique (112) et le second élément à fibre optique (126) sont connectés de manière telle que l'au moins un signal optique (122) puisse être guidé depuis la première âme (118) du premier élément à fibre optique (112) jusqu'au moins une des tiges de contrainte (136) du second élément à fibre optique (126), ou vice versa.

4. Détecteur optique (110) selon l'une quelconque des revendications précédentes, dans lequel le premier matériau (138) est adapté pour être converti en le second matériau (140) lors du contact avec un composé chimique (142) comprenant un fluide, dans lequel le fluide est sélectionné parmi au moins un d'un gaz, d'un liquide, de particules, ou d'un mélange, d'un aérosol, ou d'une suspension de ceux-ci.

5. Détecteur optique (110) selon la revendication précédente, dans lequel le premier matériau (138) est sélectionné parmi au moins un de silice ($SiO_2$), de carbonate de calcium ($CaCO_3$), d'alumine ($Al_2O_3$), d'hydroxyde d'oxyde d'aluminium ($AlO(OH)$), ou une version dopée de ceux-ci, dans lequel le premier matériau (138) est adapté pour être converti en le second matériau (140) lors du contact avec au moins un d'acide hydrofluorique (HF), d'acide hydrochlorique (HCl), ou d'acide hydrobromique (HBr) en tant que le composé chimique (142).

6. Détecteur optique (110) selon l'une quelconque des revendications précédentes, dans lequel le premier matériau (138) est adapté pour être converti en le second matériau (140) de manière telle que le premier matériau (138) soit au moins partiellement dissout par le composé chimique (142), étant ainsi au moins partiellement enlevé du second élément à fibre optique (126) .

7. Détecteur optique (110) selon l'une quelconque des revendications précédentes, dans lequel le second élément à fibre optique (126) est situé au niveau d'une facette du premier élément à fibre optique (112).

8. Détecteur optique (110) selon l'une quelconque des revendications précédentes, dans lequel un élément à fibre à âme creuse (158) est situé entre le premier élément à fibre optique (126) et le second élément à fibre optique (126), dans lequel une combinaison de l'élément à fibre à âme creuse (158) et du second élément à fibre optique (126) est agencée sous forme d'élément interféromètre de Fabry-Pérot (160).

9. Détecteur optique (110) selon la revendication précédente, dans lequel le premier matériau (138) est adapté pour être converti en le second matériau (140) de manière telle que la combinaison de l'élément à fibre à âme creuse (158) et du second élément à fibre optique (126) adaptée pour servir d'élément interféromètre de Fabry-Pérot (160) soit conçu pour changer sa longueur résonante.

10. Procédé pour une détection d'un composé chimique (142), le procédé comprenant les étapes suivantes :

a) la fourniture d'un détecteur optique (110) selon l'une quelconque des revendications précédentes ;
b) le guidage d'au moins un signal optique (122) le long du premier élément à fibre optique (112) jusqu'au second élément à fibre optique (126) ;
c) la mise d'un premier matériau (138) compris par une partie du second élément à fibre optique (126) en contact avec au moins un composé chimique (142) destiné à être détecté, sur quoi le premier matériau (138) est converti en un second matériau (140) lors d'une réaction chimique avec le composé chimique (142) ; moyennant quoi au moins un signal optique modifié (146) est généré en fonction d'une conversion du premier matériau (138) en le second matériau (140) par le composé chimique (142) ;
d) le guidage de l'au moins un signal optique modifié (146) le long du premier élément à fibre optique (112) jusqu'à un dispositif d'évaluation (148) ; et
e) la détermination d'au moins une propriété connexe au composé chimique (142) en évaluant l'au moins un signal optique modifié (146) dans le dispositif d'évaluation (148).

11. Procédé selon la revendication précédente, dans lequel la preuve d'une présence du composé chimique (142) destiné à être détecté est déduite et/ou dans lequel une concentration accumulée du composé chimique (142) destiné à être détecté est déterminée dans l'étape e).

12. Dispositif d'énergie électrochimique comprenant au moins un détecteur optique (110) selon l'une quelconque des revendications précédentes faisant référence au détecteur optique (110), dans lequel le détecteur optique (110) est attaché à ou intégré dans au moins une partie du dispositif d'énergie électrochimique.

13. Dispositif d'énergie électrochimique selon la revendication précédente, dans lequel le détecteur optique est attaché à ou intégré dans au moins un d'un séparateur ou d'une électrode compris par le dispositif d'énergie électrochimique.

Fig. 1

Fig. 2a

Fig. 2b

Fig. 2c

EP 3 517 938 B1

## Fig. 3a

$[H_2O]$ = 0 ppm

144      126

112

150 μm

## Fig. 3b

$[H_2O]$ = 500 ppm

144     126

112          136

142

150 μm

## Fig. 3c

$[H_2O]$ = 2000 ppm

136

142

150 μm

112      114      126

## Fig. 3d

$[H_2O]$ = 5000 ppm

136

142

150 μm

112      114      126

EP 3 517 938 B1

Fig. 4a

Fig. 4b

EP 3 517 938 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6157442 A
- US 20140203783 A1
- US 20160028129 A1
- US 20160018319 A1
- US 5610393 A
- US 2015303723 A1
- EP 2565630 A1
- JP H04315108 A

### Non-patent literature cited in the description

- **L. TERBORG ; S. WEBER ; F. BLASKE ; S. PASSERINI ; M. WINTER ; U. KARST ; S. NOWAK.** Investigation of thermal aging and hydrolysis mechanisms in commercial lithium ion battery electrolyte. *J. Power Sources,* 2013, vol. 242, 832
- **S.-T. MYUNG ; K. IZUMI ; S. KOMABA ; Y.-K. SUN ; H. YASHIRO ; N. KUMAGAI.** Role of alumina coating on Li-Ni-Co-Mn-O particles as positive electrode material for lithium-ion batteries. *Chem. Mater,* 2005, vol. 17, 3695
- **N.P.W. PIECZONKA ; Z. LIU ; P. LU ; K.L. OLSON ; J. MOOTE ; B.R. POWELL ; J.H. KIM.** Understanding transition-metal dissolution behavior in LiNi0.5Mn1.5O4 high-voltage spinel for lithium ion batteries. *J. Phys. Chem. C,* 2013, vol. 117, 15947
- **I-C. CHEN ; S.-S. LIN ; T.-J. LIN ; J.-K. DU.** Detection of hydrofluoric acid by a SiO2 sol-gel coating fiber-optic probe based on reflection-based localized surface plasmon resonance. *Sensors,* 2011, vol. 11, 1907-23
- **M.-T. LEE.** *Communications of the American Ceramic Society,* 1984, C-21-C-22
- **A. GUÉGUEN ; D. STREICH ; M. HE ; M. MENDEZ ; F.F. CHESNEAU ; P. NOVAK ; E.J. BERG.** Decomposition of LiPF6 in high energy lithium-ion batteries studied with online electrochemical mass spectrometry. *J. Electrochem. Soc.,* 2016, vol. 163, A1095-A1100